# EUROPEAN PATENT APPLICATION

(11) **EP 4 800 859 A1**
(43) Date of publication of application: **02.09.2026**
(21) Application number: 24921738.1
(22) Date of filing: 12.12.2024
(51) Int. Cl.: H01S 5/343

(54) **VERTICAL-CAVITY SURFACE-EMITTING LASER**

(30) Priority: 29.01.2024 US 202463626181 P; 06.11.2024 CN 202411581627
(71) Applicant: Vertilite Co., Ltd., Changzhou, Jiangsu 213167 (CN)
(72) Inventor: ZHANG, Cheng, Hangzhou, Jiangsu 213167 (CN); LIANG, Dong, Hangzhou, Jiangsu 213167 (CN)
(74) Representative: HGF
(86) International application number: PCT/CN2024/138902
(87) International publication number: WO 2025/161716

(57) **Abstract**

The present disclosure relates to a vertical-cavity surface-emitting laser. The vertical-cavity surface-emitting laser comprises a first distributed Bragg reflector (12), an active layer (13), an oxide layer (14) and a second distributed Bragg reflector (15) that are located on the front surface of a substrate (11) and are sequentially stacked in a direction away from the substrate (11). The active layer (13) comprises a first heterojunction layer (131), a quantum well layer (132) and a second heterojunction layer (133) that are sequentially stacked in a direction away from the substrate (11), wherein materials of the first heterojunction layer (131) and the second heterojunction layer (133) both comprise aluminum gallium arsenide, and the aluminum composition in the first heterojunction layer (131) and the second heterojunction layer (133) gradually increases in a direction away from the quantum well layer (132).

## Description

### CROSS-REFERENCE TO RELATED APPLICATIONS

This disclosure claims priority to U.S. patent application No. 63/626,181, entitled "High speed VCSEL with narrow SCH layers" and filed with the United States Patent and Trademark Office on January 29, 2024, and Chinese patent application No. 202411581627.0, entitled "VERTICAL-CAVITY SURFACE-EMITTING LASER" and filed with the China National Intellectual Property Administration on November 6, 2024. The contents of the above identified patent applications are herein incorporated in their entireties by reference.

### TECHNICAL FIELD

The present disclosure relates to the field of semiconductor lasers, and particularly to a vertical-cavity surface-emitting laser.

### BACKGROUND

A Vertical-Cavity Surface-Emitting Laser (VCSEL) is a type of semiconductor laser, and has a basic structure primarily including an active layer and Distributed Bragg Reflectors (DBRs) that have a function of optical feedback.

The VCSEL can generate a circular spot easy to couple with optical fibers, thereby exhibiting advantages such as high modulation rate, low transmission loss, high temperature stability, low threshold current, low power consumption, high reliability, and easy integration with other optical devices.

However, with the development of high-speed data communication technologies, the market requires improved bandwidth performance from VCSELs. Therefore, improving the bandwidth supported by VCSELs without enlarging their size has become a significant research focus.

### SUMMARY

In some embodiments, a first aspect of the present disclosure, a vertical-cavity surface-emitting laser (VCSEL) is provided, including a first distributed Bragg reflector (DBR), an active layer, an oxide layer, and a second DBR, which are stacked sequentially in a direction away from a substrate and arranged on a front side of the substrate. The active layer includes a first heterojunction layer, a quantum well layer, and a second heterojunction layer, which are stacked sequentially in the direction away from the substrate. A material of the first heterojunction layer and a material of the second heterojunction layer both include aluminum gallium arsenide. An aluminum composition in the first heterojunction layer and an aluminum composition in the second heterojunction layer increase gradually in directions away from the quantum well layer, respectively.

In some embodiments, the first heterojunction layer includes a first portion positioned between a central cross-section of the first heterojunction layer and the quantum well layer. An aluminum composition in the first portion of the first heterojunction layer is in a range from 10% to 40%.

In some embodiments, the second heterojunction layer includes a first portion positioned between a central cross-section of the second heterojunction layer and the quantum well layer. An aluminum composition in the first portion of the second heterojunction layer is in a range from 10% to 40%.

In some embodiments, the aluminum composition in the first heterojunction layer and the aluminum composition in the second heterojunction layer increase linearly or in a graded manner in the directions away from the quantum well layer, respectively.

In some embodiments, the quantum well layer includes quantum well sub-layers and barrier layers, and the quantum well sub-layers and barrier layers are alternately stacked in the direction away from the substrate. In the quantum well layer, the topmost quantum well sub-layer is adjacent to the second heterojunction layer, and the bottommost quantum well sub-layer is adjacent to the first heterojunction layer.

In some embodiments, the quantum well layer includes: a first aluminum gallium arsenide barrier layer positioned between the bottommost quantum well sub-layer and the first heterojunction layer, and a second aluminum gallium arsenide barrier layer positioned between the topmost quantum well sub-layer and the second heterojunction layer. An aluminum composition in the first aluminum gallium arsenide barrier layer is in a range from 10% to 40%, and an aluminum composition in the second aluminum gallium arsenide barrier layer is in a range from 10% to 40%.

In some embodiments, a material of each of the barrier layers includes aluminum gallium arsenide or aluminum gallium arsenide phosphide. An aluminum composition in each of the barrier layers is constant in a direction away from the quantum well layer.

In some embodiments, the oxide layer has an oxidation aperture. The oxidation aperture is positioned within an orthographic projection of the second DBR on a top surface of the oxide layer.

In some embodiments, a ratio of the maximum opening dimension to the minimum opening dimension of the oxidation aperture is in a range from 1.25 to 1.35.

In some embodiments, the VCSEL further includes a first contact layer positioned on a top surface of the first DBR and around the active layer, and a second contact layer positioned on a top surface of the second DBR and around the oxidation aperture.

In some embodiments, a material of the first contact layer includes aluminum gallium arsenide or aluminum gallium arsenide phosphide, and an aluminum composition in the first contact layer is in a range from 10% to 40%.

In some embodiments, a material of the second contact layer includes aluminum gallium arsenide or aluminum gallium arsenide phosphide, and an aluminum composition in the second contact layer is in a range from 10% to 40%.

In some embodiments, a second aspect of the present disclosure, a laser array is provided, and the laser array includes a plurality of VCSELs of any embodiments above arranged in rows and columns. VCSELs in the same row are connected to a corresponding row selection line. VCSELs in the same column are connected to a corresponding column selection line. VCSELs in different rows are connected to different row selection lines, respectively. VCSELs in different columns are connected to different column selection lines, respectively. A VCSEL connected to a selected row selection line and a selected column selection line is activated by selecting the row selection line and the column selection line.

In some embodiments, a third aspect of the present disclosure, a light-emitting device is provided, including the VCSEL according to any one of the above embodiments.

In some embodiments, a fourth aspect of the present disclosure, a light-emitting device is provided, including the laser array according to any one of the above embodiments.

Details in one or more embodiments are provided in the following accompany drawings and description. Other features, objectives, and advantages of the present disclosure will become apparent from the description, the accompanying drawings, and the claims.

### BRIEF DESCRIPTION OF THE DRAWINGS

To illustrate the technical solutions of embodiments of the present disclosure more clearly, the drawings to be used in describing the embodiments shall be briefly introduced below. Obviously, the drawings in the following description merely involve some embodiments of the present disclosure. For those skilled in the art, additional drawings of other embodiments can be obtained based on these drawings without inventive efforts.
FIGS. 1 to 3 show schematic longitudinal-sectional views of VCSELs provided in different embodiments of the present disclosure;
FIG. 4 shows a schematic perspective view of a VCSEL provided in an embodiment of the present disclosure;
FIG. 5 shows a schematic diagram of refractive index profile versus position of a heterojunction layer and an active layer in a VCSEL according to an embodiment of the present disclosure, where diagram (1) is a schematic diagram of refractive index profile versus position of a heterojunction layer and an active layer in a VCSEL capable of supporting 50G bandwidth in prior art, and diagram (2) is a schematic diagram of refractive index profile versus position of a heterojunction layer and an active layer according to an embodiment of the present disclosure;
FIG. 6 shows a schematic top view of a laser array provided in an embodiment of the present disclosure;
FIG. 7 shows a schematic longitudinal-sectional view of a laser array provided in another embodiment of the present disclosure, and may be a schematic longitudinal-sectional view taken along an AA' direction shown in FIG. 6;
FIG. 8 shows a schematic flowchart of a VCSEL fabrication method provided in an embodiment of the present disclosure.

### DETAILED DESCRIPTION OF THE EMBODIMENTS

To facilitate understanding of the present disclosure, the present disclosure will be described more comprehensively with reference to the drawings. Embodiments of the present disclosure are shown in the drawings. However, the present disclosure may be implemented in multiple distinct embodiments which are not limited to the embodiments described herein. In contrast, these embodiments are provided to make the disclosure of the present disclosure more thorough and comprehensive.

Unless otherwise defined, all technical and scientific terms used herein have the same meanings as commonly understood by those skilled in the art of the technical field of the present disclosure. The terms used in the specification of the present disclosure are for the purpose of describing specific embodiments only and are not intended to limit the present disclosure. The term "and/or" as used herein includes arbitrary and all combinations of one or more related listed items.

It should be understood that, when an element or a layer is referred to as being "on", "adjacent to", "connected to", or "coupled to" another element or layer, it can be directly on, adjacent to, connected to, or coupled to the other element or layer, or an intervening element or layer may be present. In contrast, when an element is referred to as being "directly on", "directly adjacent to", "directly connected to", or "directly coupled to" another element or layer, no intervening elements or layers are present. It should be understood that, although terms such as "first", "second", and "third" can be used to describe various elements, components, regions, layers, and/or parts, these elements, components, regions, layers, and/or parts should not be limited by these terms. These terms are only used to distinguish an element, a component, a region, a layer, or a part from another. Thus, without departing from the teachings of the present disclosure, a first element, a first component, a first region, a first layer, or a first part discussed below could be termed a second element, a second component, a second region, a second layer, or a second part.

Spatial relationship terms such as "beneath", "below", "lower", "under", "above", and "upper" can be used herein for convenience to describe the relationship of an element or feature to another element or feature as illustrated in the drawings. It should be understood that, these terms are intended to include different orientations of a device in use or operation in addition to orientations shown in the drawings. For example, if the device in the drawings is inverted, an element or a feature described as "below" or "under" another element or another feature would then be oriented "above" the other element or feature. Thus, the terms like "below" and "under" can include both upward and downward orientations. The device can be otherwise oriented (rotated 90 degrees or at other orientations), and the spatial descriptive terms used herein can be interpreted accordingly.

The terms used herein are for the purpose of describing specific embodiments only and are not intended to limit the present disclosure. As used herein, the singular forms "a", "an", and "the" are intended to include the plural forms as well, unless the context clearly indicates otherwise. It should also be understood that the terms like "consist of" and/or "include" when used in the specification, specify the presence of features, integers, steps, operations, elements, and/or components, but not exclude the presence or addition of one or more other features, integers, steps, operations, elements, components, and/or groups. As used herein, the term "and/or" includes arbitrary and all combinations of the related listed items.

Embodiments of the application are described herein with reference to schematic sectional views of ideal embodiments (and intermediate structures) of the present disclosure. As such, variations from the shown shapes due to, for example, manufacturing techniques and/or tolerances, are to be anticipated. Thus, the embodiments of the present disclosure should not be limited to the specific shapes of regions shown herein but include deviations in shapes due to, for example, manufacturing. Accordingly, the regions shown in the drawings are illustrative, and shapes of thereof are not intended to illustrate actual shapes of the regions of the device and are not intended to limit the scope of the present disclosure.

A multilayer structure described in an embodiment of the present disclosure may be formed layer-by-layer or integrally, and adjacent two layers in the structure may be in contact with each other or spaced apart.

In an embodiment of the present disclosure, being perpendicular to a substrate may refer to being perpendicular to an upper surface substrate, and being parallel to a substrate may refer to being parallel to an upper surface of a substrate.

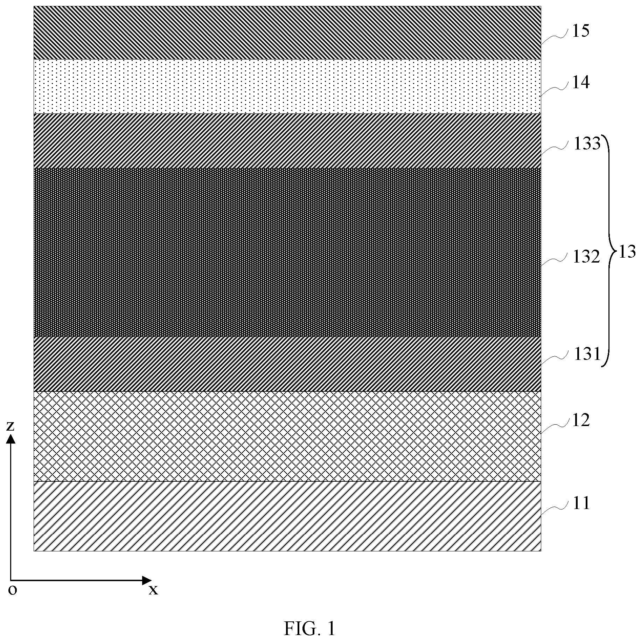

Referring to FIG. 1 to FIG. 7, it should be noted that the drawings provided in the embodiment are merely schematic illustrations of the basic concepts of the present disclosure. Although only components relevant to the present disclosure are shown in the drawings, and they are not drawn according to the number, shape, or size thereof in actual implementation, and the form, number, or proportion of the components in the actual implementation can be arbitrarily changed, and the component layout may be more complex.

After entering the information age, rapid development of the internet technology has greatly boosted the demand for high-speed data communications. Major network giants have also established ultra-large-scale data centers, which have also put forward higher requirements for high-speed data transmission systems at the same time. Thus, establishing high-bandwidth and low-power-consumption data communication systems is an inevitable trend in the development of high-speed data communications in the future.

The VCSEL can generate a circular spot easy to couple with optical fibers, thereby exhibiting advantages such as high modulation rate, low transmission loss, high temperature stability, low threshold current, low power consumption, high reliability, and easy integration with other optical devices. Therefore, VCSELs serve as light sources currently in mainstream high-speed communication applications.

A basic structure of the VCSEL primarily includes an active layer and Distributed Bragg Reflectors (DBRs) that have a function of optical feedback. The active layer is arranged between DBRs at two sides, which collectively form a Fabry-Perot resonant cavity. A pump source generates optical gain by spontaneous radiation through a gain medium in the active layer. Light waves within the resonant cavity reflect between top and bottom DBRs to form a stable standing wave, which is continuously amplified by stimulated radiation, ultimately forming a laser light.

Referring to FIG. 1, in some embodiments, a VCSEL is provided, including a first DBR 12, an active layer 13, an oxide layer 14, and a second DBR 15, which are stacked sequentially in a direction away from the substrate 11 (e.g., in an oz-direction) and arranged on a front side of a substrate 11. The active layer 13 includes a first heterojunction layer 131, a quantum well layer 132, and a second heterojunction layer 133, which are sequentially stacked in the direction away from the substrate 11. The material of the first heterojunction layer 131 and the material of the second heterojunction layer 133 both includes aluminum gallium arsenide, and the aluminum composition (e.g., aluminum atomic percentage) in the first heterojunction layer 131 and the aluminum composition in the second heterojunction layer 133 (e.g., aluminum atomic percentage) increase gradually in directions away from the quantum well layer 132, respectively.

Referring to FIG. 1, the active layer 13 includes the quantum well layer 132 between the first heterojunction layer 131 and the second heterojunction layer 133, and the material of the first heterojunction layer 131 and the material of the second heterojunction layer 133 both include AlGaAs, and the aluminum composition in the first heterojunction layer 131 and the aluminum composition in the second heterojunction layer 133 increase gradually in the directions away from the quantum well layer 132, respectively, therefore the time for carriers to enter the active layer 13 through the first heterojunction layer 131 or through the second heterojunction layer 133 is reduced, thereby improving the bandwidth supported by the VCSEL without enlarging the size of the VCSEL.

Exemplarily, referring to FIG. 1, the substrate 11 may be made of semiconductor material, insulative material, semi-insulative material, or any combination thereof. The substrate 11 can be a single layer structure or a multilayer structure. For example, the substrate 11 may be a gallium arsenide (GaAs) substrate, an indium phosphide (InP) substrate, or another III-V semiconductor substrate or II-VI semiconductor substrate. The type of the substrate should not limit the protection scope of the present disclosure. The substrate 11 can include one or more of word lines, bit lines, and components such as transistors, which are omitted as they are not closely related to the key inventive aspects of this solution.

Exemplarily, continuing to refer to FIG. 1, the one or more components such as the word lines, the bit lines, and the transistors are generally fabricated in the substrate 11. To reduce the lattice mismatch between the first DBR 12 and the substrate 11, or to prevent possible defects in the substrate 11 form taking adverse effects on the first DBR 12, a buffer layer (not shown) may be disposed between the substrate 11 and the first DBR 12 to effectively improve the yield and reliability of semiconductor device fabrication.

Exemplarily, continuing to refer to FIG. 1, a central cross-section of a quantum well region of the quantum well layer 132 is positioned within an antinode region of a standing wave electric field of the VCSEL. z represents a position of an antinode, and the antinode region is [z-λ/8, z+λ/8], where λ represents the wavelength of a standing wave, thereby avoiding the energy loss of internal layers as much as possible, and enhancing the light emission efficiency and light emission quality of the VCSEL.

Continuing to refer to FIG. 1, in some embodiments, the first heterojunction layer 131 includes a first portion (not shown) positioned between the central cross-section thereof and the quantum well layer 132. The aluminum composition in the first portion of the first heterojunction layer 131 is in a range from 10% to 40%. For example, the aluminum composition in the first portion of the first heterojunction layer 131 may be 10%, 20%, 30%, or 40%, etc.

For example, continuing to refer to FIG. 1, the aluminum composition (e.g., aluminum atomic percentage) in the first portion of the first heterojunction layer 131 may be 10%, and the aluminum composition in the remaining portion of the first heterojunction layer 131 may be 90%. The portion of the first heterojunction layer 131 adjacent to the quantum well layer 132 is configured to have a relatively low aluminum composition, and the portion of the first heterojunction layer 131 away from the quantum well layer 132 is configured to have a relatively high aluminum composition, thus achieving a decrease in the time for carriers to enter the active layer 13 through the first heterojunction layer 131 without changing the thickness of the first heterojunction layer 131, and thereby improving the bandwidth supported by the VCSEL without enlarging the size of the VCSEL.

Continuing to refer to FIG. 1, in some embodiments, the second heterojunction layer 133 includes a first portion positioned between the central cross-section thereof and the quantum well layer 132. The aluminum composition in the first portion of the second heterojunction layer 133 is in a range from 10% to 40%. For example, the aluminum composition in the first portion of the second heterojunction layer 133 may be 10%, 20%, 30%, or 40%, etc.

Exemplarily, referring to FIG. 1, the aluminum composition in the first portion of the second heterojunction layer 133 may be 10%, and the aluminum composition in the remaining portion of the second heterojunction layer 133 may be 90%. The portion of the second heterojunction layer 133 adjacent to the quantum well layer 132 is configured to have a relatively low aluminum composition, the portion of the second heterojunction layer 133 away from the quantum well layer 132 is configured to have a relatively high aluminum composition, thus achieving a decrease in the time for carriers to enter the active layer 13 through the second heterojunction layer 133 without changing the thickness of the second heterojunction layer 133, and thereby improving the bandwidth supported by the VCSEL without enlarging the size of the VCSEL.

Continuing to refer to FIG. 1, in some embodiments, the aluminum composition in the first heterojunction layer 131 and the aluminum composition in the second heterojunction layer 133 increase linearly or in a graded manner in directions away from the quantum well layer 132, respectively, thereby meeting fabrication requirements of different application scenarios.

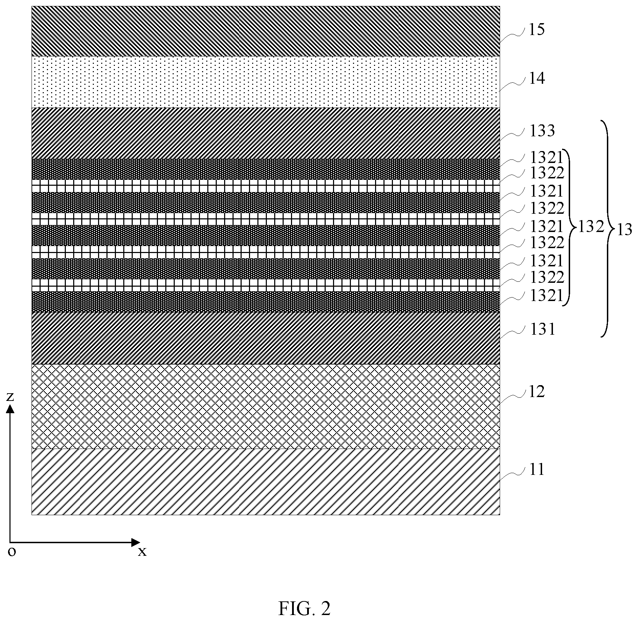

Referring to FIG. 2, in some embodiments, the quantum well layer 132 includes quantum well sub-layers 1321 and barrier layers 1322, which are alternately stacked in a direction away from the substrate 11. In the quantum well layer 132, the topmost quantum well sub-layer 1321 is adjacent to the second heterojunction layer 133, and the bottommost quantum well sub-layer 1321 is adjacent to the first heterojunction layer 131.

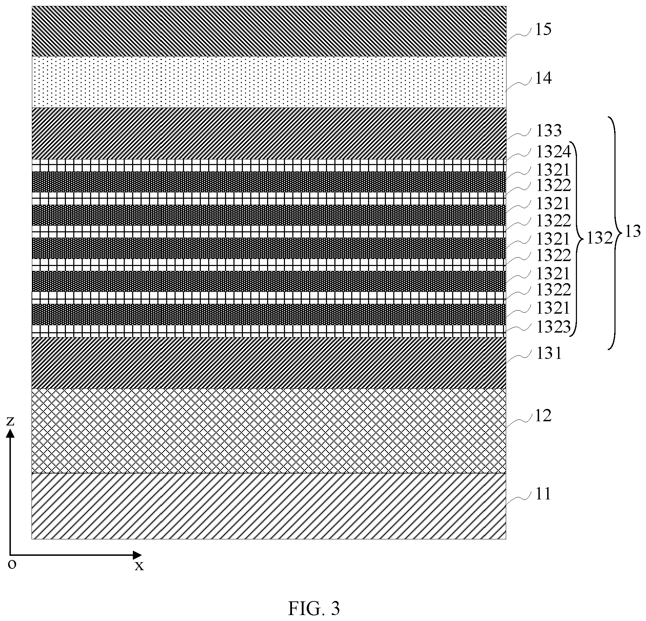

Referring to FIG. 3, in some embodiments, the quantum well layer 132 includes a first aluminum gallium arsenide barrier layer 1323 and a second aluminum gallium arsenide barrier layer 1324. The first aluminum gallium arsenide barrier layer 1323 is positioned between the bottommost quantum well sub-layer 1321 and the first heterojunction layer 131. The second aluminum gallium arsenide barrier layer 1324 is positioned between the topmost quantum well sub-layer 1321 and the second heterojunction layer 133. The aluminum composition in the first aluminum gallium arsenide barrier layer 1323 may be set to be the same as that in the first portion of the second heterojunction layer 133.

Exemplarily, the aluminum composition in the first aluminum gallium arsenide barrier layer may be in a range from 10% to 40%. For example, the aluminum composition in the first aluminum gallium arsenide barrier layer may be 10%, 20%, 30%, or 40%, etc.

Exemplarily, the aluminum composition in the second aluminum gallium arsenide barrier layer may be in a range from 10% to 40%. For example, the aluminum composition in the second aluminum gallium arsenide barrier layer may be for 10%, 20%, 30%, or 40%, etc.

Referring to FIG. 3, in some embodiments, the thickness of the first heterojunction layer 131 or the second heterojunction layer 133 may be greater than 0 and less than 25 nm. The thickness of the barrier layer 1322 may be greater than 0 and less than 20 nm. For example, the thickness of the first heterojunction layer 131 or the second heterojunction layer 133 may be 5 nm, 10 nm, 15 nm, 20 nm, or 25 nm, etc. The thickness of the barrier layer 1322 may be 5 nm, 10 nm, 15 nm, or 20 nm, etc.

Referring to FIG. 3, in some embodiments, the thickness of the first heterojunction layer 131 or the second heterojunction layer 133 may be greater than 0 and less than 20 nm. The thickness of the barrier layer 1322 may be greater than 0 and less than 15 nm. For example, the thickness of the first heterojunction layer 131 or the second heterojunction layer 133 may be 5 nm, 10 nm, 15 nm, or 20 nm, etc. The thickness of the barrier layer 1322 may be 5 nm, 10 nm, or 15 nm, etc.

Referring to FIG. 3, in some embodiments, each barrier layer 1322 includes aluminum gallium arsenide or aluminum gallium arsenide phosphide. The aluminum composition in the barrier layer 1322 remains constant in a direction away from the quantum well layer 132.

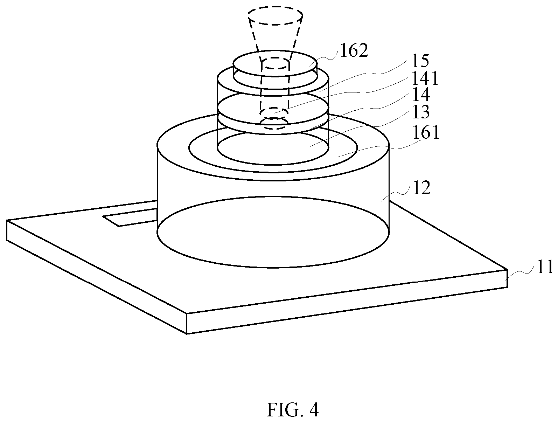

Referring to FIG. 4, in some embodiments, the oxide layer 14 has an oxidation aperture 141. The oxide layer 14 provides at least the effects of optical confinement and electrical confinement. The oxidation aperture 141 is positioned within the orthographic projection of the second DBR 15 on the top surface of the oxide layer 14.

In some embodiments, a ratio of the maximum opening dimension to the minimum opening dimension of the oxidation aperture is in a range from 1.25 to 1.35. For example, the ratio of the maximum opening dimension to the minimum opening dimension of the oxidation aperture may be 1.25, 1.30, or 1.35, etc.

In some embodiments, the opening dimension of the oxidation aperture is in a range from 6 µm to 9 µm. For example, the opening dimension of the oxidation aperture may be 6 µm, 7 µm, 8 µm, or 9 µm, etc.

Referring to FIG. 4, in some embodiments, the VCSEL further includes a first contact layer 161 and a second contact layer 162. The first contact layer 161 is positioned on the top surface of the first DBR 12 and around the active layer 13. The second contact layer 162 is positioned on the top surface of the second DBR 15 and around the oxidation aperture 141.

Referring to FIG. 4, in some embodiments, the conductivity types of the first contact layer 161 and the first DBR 12 are n-type. The thickness of the first contact layer 161 is an integer multiple of a half-wavelength. The half-wavelength is half the wavelength of the standing wave electric field of the VCSEL, thus avoiding suppression of reflected waves and improving the light emission efficiency.

In some embodiments, the first contact layer includes aluminum gallium arsenide or aluminum gallium arsenide phosphide. The aluminum composition in the first contact layer is the same as that in the first portion of the first heterojunction layer. For example, the aluminum composition in the first contact layer may be in a range from 10% to 40%.

In some embodiments, the second contact layer includes aluminum gallium arsenide or aluminum gallium arsenide phosphide. The aluminum composition in the second contact layer is the same as that in the first portion of the second heterojunction layer. For example, the aluminum composition in the second contact layer may be in a range from 10% to 40%.

Exemplarily, referring to FIGS. 1 to 3, the optical thickness of the active layer 13, the optical thickness of the first DBR 12, and the optical thickness of the second DBR 15 collectively define the wavelength of the resonant cavity of the VCSEL, which can be designed to be within an emitted wavelength range of the active layer 13 to achieve a laser emission.

As an example, the central cross-section of the quantum well region of the quantum well layer is positioned within the antinode region of the standing wave electric field of the VCSEL. z represents a position of an antinode, and the antinode region is [z-λ/8, z+λ/8], where λ represents the wavelength of a standing wave, thereby avoiding the energy loss of internal layers as much as possible, and enhancing the light emission efficiency and light emission quality of the VCSEL.

In some embodiments, referring to FIGS. 1 to 3, the first DBR 12 may include multiple stacked first reflective layers (not shown). Each of the first reflective layers includes a first reflective sub-layer (not shown) and a second reflective sub-layer (not shown) with different refractive indices. The first reflective sub-layer of the bottommost first reflective layer in the first DBR 12 is adjacent to the substrate 11. In adjacent first reflective layers, the first reflective sub-layer is adjacent to the second reflective sub-layer. The first reflective sub-layer includes indium gallium phosphide, and the lattice constant of the compound in the second reflective sub-layer is greater than that of indium gallium phosphide.

In some embodiments, referring to FIGS. 1 to 3, the material of the first reflective sub-layer includes indium gallium phosphide, and the lattice constant of the compound in the second reflective sub-layer is greater than that of the indium gallium phosphide, so that stresses among the first reflective layers of the first DBR 12 can be counteracted by each other, thereby reducing warpage. A conventional VCSEL can achieve very high reflectivity (99%) through a reflector of epitaxial layers, which are alternately formed by two materials with different refractive indices with a quarter-wavelength optical thick, which can meet special requirements of the device for the reflector. However, a lattice difference between the substrate and the epitaxial layers causes a stress accumulation in the epitaxial layers. Additionally, too large an overall thickness of the epitaxial layers of the reflector leads to a large warpage of the epitaxial wafer, thus adversely affecting the yield of the semiconductor chip. Regarding the VCSEL provided in the embodiments of the present disclosure, the multiple first reflective layers are arranged and stacked in the first DBR 12, each of the first reflective layers includes the first reflective sub-layer made of indium gallium phosphide and the second reflective sub-layer, which have different refractive indices, the first reflective sub-layer of the bottommost first reflective layer in the first DBR 12 is adjacent to the substrate 11, and in adjacent first reflective layers, the first reflective sub-layer is adjacent to the second reflective sub-layer, and the lattice constant of the compound in the second reflective sub-layer is greater than that of indium gallium phosphide, so that stresses among the reflective sub-layers can be counteracted by each other, thereby reducing the warpage and improving the yield of semiconductor chip.

In some embodiments, referring to FIGS. 1-3, the second DBR 14 includes multiple stacked second reflective layers (not shown). Each of the second reflective layer includes a third reflective sub-layer (not shown) and a fourth reflective sub-layer (not shown) with different refractive indices. In adjacent second reflective layers, the third reflective sub-layer is adjacent to the fourth reflective sub-layer. The third reflective sub-layer and the fourth reflective sub-layer each include aluminum gallium arsenide, and the aluminum composition in the third reflective sub-layer and the aluminum composition in the fourth reflective sub-layer are different.

Exemplarily, the materials of the third reflective sub-layer and the fourth reflective sub-layer include AlₓGa₁₋ₓAs. The material AlₓGa₁₋ₓAs is formed by a uniform recombination of AlAs and GaAs, and has advantages such as high carrier mobility, adjustable aluminum composition, and minimal lattice mismatch with GaAs. The third reflective sub-layer has the material AlₓGa₁₋ₓAs, where x<0.1, while the fourth reflective sub-layer has the material AlₓGa₁₋ₓAs, where x>0.9. Alternating growth of the third reflective sub-layer with high refractive indices and the fourth reflective sub-layer with low refractive indices enables the number of the periods to be increased to achieve high reflectivity, thereby meeting the specific requirements of the VCSEL structure for reflectors.

In some embodiments, the material of the first reflective sub-layer includes In_{y}Ga_{1-y}P, where y∈[0, 0.48]. For example, y may be 0, 0.1, 0.15, 0.2, 0.25, 0.3, 0.35, 0.4, or 0.48, etc.

In some embodiments, the material of the second reflective sub-layer includes aluminum arsenide or aluminum gallium arsenide.

Exemplarily, the material of the first reflective sub-layer may be In_{0.48}Ga_{0.52}P, and the material of the substrate may be GaAs. The lattice constant of In_{0.48}Ga_{0.52}P is smaller than that of the substrate made of GaAs, and the first reflective sub-layer subjects to tensile stresses. The material of the second reflective sub-layer includes AlₓGa₁₋ₓAs, where it is usually satisfied that x>0.9. The second reflective sub-layer has a lattice constant greater than that of In_{0.48}Ga_{0.52}P, and subjects to pressive stresses. Thus, the tensile and pressive stresses within each DBR period (i.e., each first reflective layer) are counteracted by each other, thereby reducing the warpage of the epitaxial wafer.

Specifically, for the VCSEL with a wavelength of 940 nm, the refractive index difference between AlGaAs having a high aluminum composition and AlGaAs having a low aluminum composition is about 0.465, while the refractive index difference between In_{0.48}Ga_{0.52}P and AlGaAs is about 0.246. To obtain a sufficient reflectivity, the DBR made of the material InGaP can achieve low warpage while allowing for a relatively large thickness of the DBR.

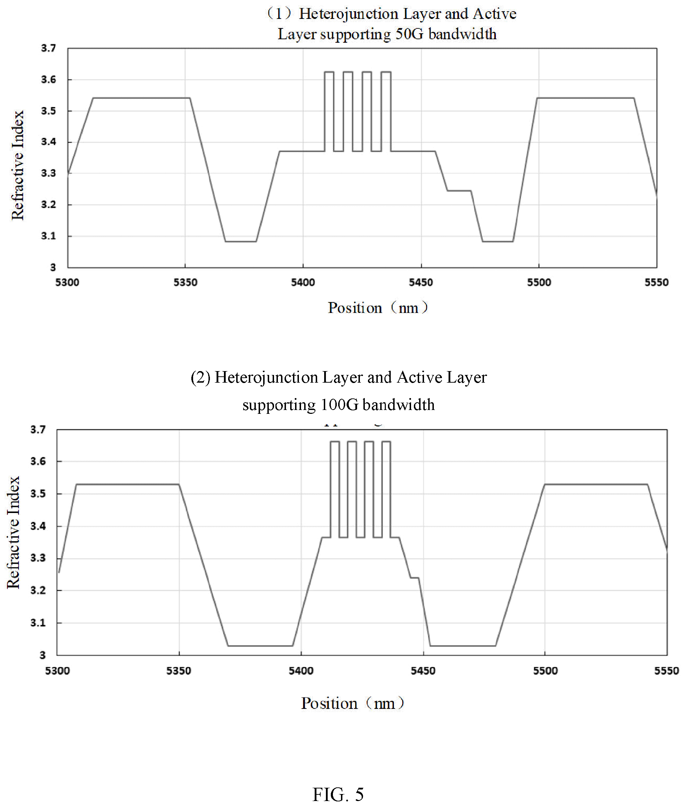

Referring to FIG. 5, in some embodiments, diagram (1) in FIG. 5 is a schematic diagram refractive index profile versus position of a heterojunction layer and an active layer in a VCSEL capable of supporting 50G bandwidth in prior art. Diagram (2) in FIG. 5 is a schematic diagram refractive index profile versus position of a heterojunction layer and an active layer in a VCSEL according to an embodiment of the present disclosure. By comparing diagram (1) and diagram (2) in FIG. 5, it is evident that, in the embodiment of the present disclosure, the active layer includes the quantum well layer positioned between the first heterojunction layer and second heterojunction layer, the material of the first heterojunction layer and the material of the second heterojunction layer both include aluminum gallium arsenide, and the aluminum composition in the first heterojunction layer and the aluminum composition in the second heterojunction layer increase gradually in the directions away from the quantum well layer, respectively, therefore the time for carriers to enter the active layer through the first heterojunction layer or through the second heterojunction layer is reduced, thereby effectively improving the bandwidth supported by the VCSEL without enlarging the size of the VCSEL.

In some embodiments, a laser array is provided. The laser array includes multiple VCSELs according to any of the above embodiments, which are arranged in rows and columns. VCSELs in the same row are all connected to a corresponding row selection line. VCSELs in the same column are all connected to a corresponding column selection line. VCSELs in different rows are connected to different row selection lines respectively. VCSELs in different columns are connected to different column selection lines respectively. By selecting a row selection line and a column selection line, a VCSEL connected to both the selected row selection line and column selection line is activated, thereby realizing a common-anode driving mode. In addition, an N-type transistor having a relatively high response speed is used to drive the light-emitting structure of the VCSEL, thereby increasing the driving frequency and driving speed of the VCSEL while reducing the size of the driver system. By configuring that the VCSELs in the same row are all connected to the corresponding row selection line, the VCSELs in the same column are all connected to the corresponding column selection line, the VCSELs in different rows are connected to different row selection lines respectively, and the VCSELs in different columns are connected to different column selection lines respectively, it can be realized that, when a certain VCSEL fails, the faulty laser can be quickly located, thereby improving the operation efficiency of the device.

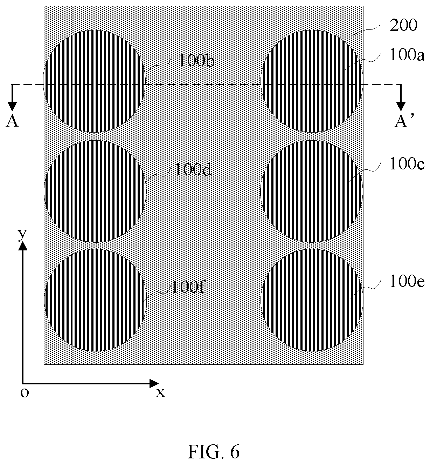

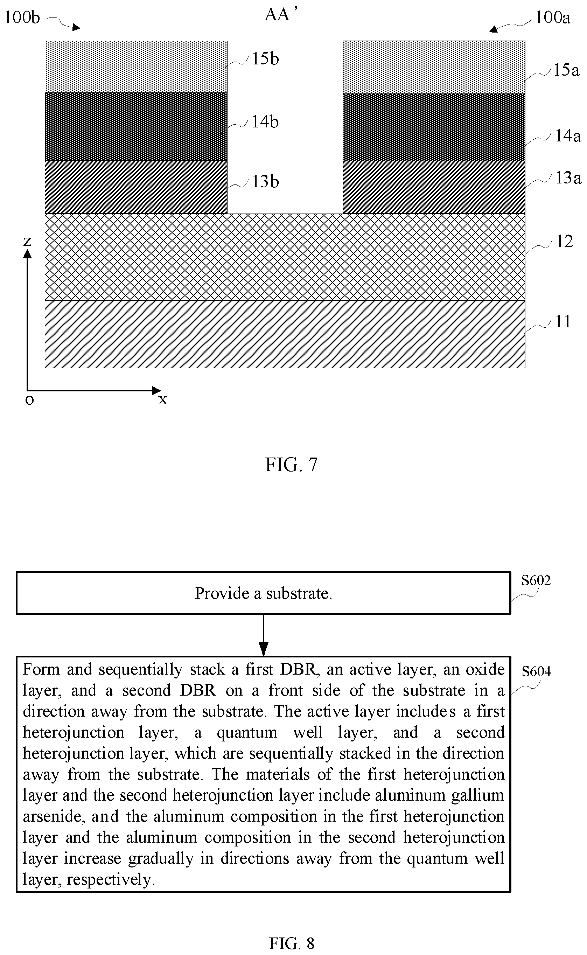

As an example, referring to FIG. 6 and FIG. 7, a first VCSEL 100a, a second VCSEL 100b, a third VCSEL 100c, a fourth VCSEL 100d, a fifth VCSEL 100e, and a sixth VCSEL 100f, which are arranged in rows and columns, share an anode electrode. Among the first VCSEL 100a, the second VCSEL 100b, the third VCSEL 100c, the fourth VCSEL 100d, the fifth VCSEL 100e, and the sixth VCSEL 100f, the cathode electrodes of adjacent VCSELs are insulative to each other. Therefore, it is realized that the cathode electrodes of different VCSELs are driven independently in the case where the anode driving is simplified, thereby meeting the driving control requirements for customized light emission schemes of the laser array.

Exemplarily, an isolation structure is arranged between adjacent VCSELs, and the isolation structure extends in a direction perpendicular to the substrate (e.g., in the oz-direction) to the top surface of the first DBR, thereby avoiding a mutual interference between adjacent VCSELs while simplifying the structure and fabrication process of the laser array.

Exemplarily, referring to FIG. 6 and FIG. 7, the isolation structure may be an isolation trench. The isolation trench is arranged between the first VCSEL 100a and the second VCSEL 100b, and extends in the direction perpendicular to the substrate (e.g., in the oz-direction) to the top surface of the first DBR 12. The active layer 13a, the oxide layer 14a, and the second DBR 15a of the first VCSEL 100a are electrically isolated from the active layer 13b, the oxide layer 14b, and the second DBR 15b of the second VCSEL 100b respectively by the isolation trench. The first VCSEL 100a and the second VCSEL 100b share the substrate 11 and the first DBR 12, thereby simplifying the fabrication process and reducing the cost of the laser array.

In some embodiments, a light-emitting device is provided, including the VCSEL according to any one of the above embodiments.

In some embodiments, a light-emitting device is provided, including the laser array according to any one of the above embodiments.

Exemplarily, referring to FIG. 8, a method for fabricating a VCSEL is provided, including:
step S602, providing a substrate; and
step S604, forming and sequentially stacking a first DBR, an active layer, an oxide layer, and a second DBR on a front side of the substrate in a direction away from the substrate. The active layer includes a first heterojunction layer, a quantum well layer, and a second heterojunction layer, which are sequentially stacked in the direction away from the substrate. The materials of the first heterojunction layer and the second heterojunction layer include aluminum gallium arsenide, the aluminum composition in the first heterojunction layer and the aluminum composition in the second heterojunction layer increase gradually in directions away from the quantum well layer, respectively.

Exemplarily, referring to FIG. 8, the active layer is configured to include the quantum well layer positioned between the first heterojunction layer and second heterojunction layer, the materials of the first heterojunction layer and second heterojunction layer include aluminum gallium arsenide, the aluminum composition in the first heterojunction layer and the aluminum composition in the second heterojunction layer increase gradually in the directions away from the quantum well layer, respectively, therefore the time for carriers to enter the active layer through the first heterojunction layer or through the second heterojunction layer is reduced, thereby improving the bandwidth supported by the VCSEL without enlarging the size of the VCSEL.

It should be understood that although the steps in the flowchart of FIG. 8 are shown sequentially according to indications of arrows, these steps are not necessarily performed in the order indicated by the arrows. Unless otherwise explicitly stated herein, there are no strict sequence constraints for performing these steps, and these steps may be performed in other orders. In addition, at least some of the steps in FIG. 8 may include multiple steps or stages. These steps or stages are not necessarily performed at the same time but may be performed at different times, and these sub-steps or stages are not necessarily performed in sequence, but may be performed alternating or in turn with other steps or at least part of the steps or stages in other steps.

Note that the above embodiments are used for illustrative purposes only but not intended to limit the present disclosure.

The embodiments in this specification are described progressively. Each embodiment focuses on its differences from other embodiments, while similar aspects across embodiments may be cross-referenced.

The technical features of the above embodiments can be combined arbitrarily. For concise description, not all possible combinations of the technical features in the above embodiments are described. However, as long as there is no contradiction in the combination of these technical features, these combinations should be considered within the scope recorded in this specification.

The above embodiments are merely some implementations of the present disclosure, they are described relatively specifically and in detail, but should not be construed as limiting the scope of this patent application. It should be pointed out that for those skilled in the art, several modifications and improvements can be made without departing from the inventive concepts of the present disclosure, and these modifications and improvements all fall within the protection scope of the present disclosure. Therefore, the protection scope of the present disclosure shall be subject to the appended claims.

## Claims

1. A vertical-cavity surface-emitting laser (VCSEL), **characterized by** comprising a first distributed Bragg reflector (DBR), an active layer, an oxide layer, and a second DBR, stacked sequentially in a direction away from a substrate and arranged on a front side of the substrate;
the active layer comprises a first heterojunction layer, a quantum well layer, and a second heterojunction layer, stacked sequentially in the direction away from the substrate; and
a material of the first heterojunction layer and a material of the second heterojunction layer both comprise aluminum gallium arsenide; and an aluminum composition in the first heterojunction layer and an aluminum composition in the second heterojunction layer increase gradually in directions away from the quantum well layer, respectively.

2. The VCSEL according to claim 1, wherein
the first heterojunction layer comprises a first portion positioned between a central cross-section of the first heterojunction layer and the quantum well layer, and an aluminum composition in the first portion of the first heterojunction layer is in a range from 10% to 40%; and /or
the second heterojunction layer comprises a first portion positioned between a central cross-section of the second heterojunction layer and the quantum well layer, and an aluminum composition in the first portion of the second heterojunction layer is in a range from 10% to 40%.

3. The VCSEL according to claim 1, wherein
the aluminum composition in the first heterojunction layer and the aluminum composition in the second heterojunction layer increase linearly or in a graded manner in the directions away from the quantum well layer, respectively.

4. The VCSEL according to any one of claims 1 to 3, wherein the quantum well layer comprises quantum well sub-layers and barrier layers, and the quantum well sub-layers and the barrier layers are alternately stacked in the direction away from the substrate; and
in the quantum well layer, the topmost quantum well sub-layer is adjacent to the second heterojunction layer, and the bottommost quantum well sub-layer is adjacent to the first heterojunction layer.

5. The VCSEL according to any one of claims 1 to 4, wherein the quantum well layer comprises:
a first aluminum gallium arsenide barrier layer positioned between the bottommost quantum well sub-layer and the first heterojunction layer; and
a second aluminum gallium arsenide barrier layer positioned between the topmost quantum well sub-layer and the second heterojunction layer;
wherein an aluminum composition in the first aluminum gallium arsenide barrier layer is in a range from 10% to 40%; and
an aluminum composition in the second aluminum gallium arsenide barrier layer is in a range from 10% to 40%.

6. The VCSEL according to any one of claims 1 to 5, wherein a material of each of the barrier layers comprises aluminum gallium arsenide or aluminum gallium arsenide phosphide; and
an aluminum composition in each of the barrier layers is constant in a direction away from the quantum well layer.

7. The VCSEL according to any one of claims 1 to 6, wherein the oxide layer has an oxidation aperture; and
the oxidation aperture is positioned within an orthographic projection of the second DBR on a top surface of the oxide layer.

8. The VCSEL according to claim 7, wherein a ratio of the maximum opening dimension of the oxidation aperture to the minimum opening dimension of the oxidation aperture is in a range from 1.25 to 1.35.

9. The VCSEL according to any one of claims 1 to 7, further comprising:
a first contact layer positioned on a top surface of the first DBR and around the active layer; and
a second contact layer positioned on a top surface of the second DBR and around the oxidation aperture.

10. The VCSEL according to claim 9, wherein a material of the first contact layer comprises aluminum gallium arsenide or aluminum gallium arsenide phosphide, and an aluminum composition in the first contact layer is in a range from 10% to 40%; and/or
a material of the second contact layer comprises aluminum gallium arsenide or aluminum gallium arsenide phosphide, and an aluminum composition in the second contact layer is in a range from 10% to 40%.
